# FASCICULE DE BREVET EUROPEEN

(11) **EP 2 839 259 B1**
(45) Date de publication et mention de la délivrance du brevet: **20.11.2019**
(21) Numéro de dépôt: 13713905.1
(22) Date de dépôt: 03.04.2013
(51) Int. Cl.: G01K 11/26, H05K 1/02, B23K 1/00, H05K 1/18, H05K 3/28

(54) **DISPOSITIF ÉLECTRIQUE ET PROCÉDÉ DE FABRICATION DE CELUI-CI**
ELEKTRISCHE VORRICHTUNG UND VERFAHREN ZU DEREN HERSTELLUNG
ELECTRICAL DEVICE AND METHOD FOR PRODUCING THE SAME

(30) Priorité: 18.04.2012 FR 1253568
(43) Date de publication de la demande: 25.02.2015
(73) Titulaire: Centre National de la Recherche Scientifique (C.N.R.S.), 75016 Paris (FR); Université de Franche-Comté, 25030 Besançon Cedex (FR)
(72) Inventeur: BALLANDRAS, Sylvain, F-25000 Besançon (FR); FRANCOIS, Bruno, F-25000 Besançon (FR)
(74) Mandataire: Lavoix
(86) Numéro de dépôt international: PCT/EP2013/057042
(87) Numéro de publication internationale: WO 2013/156309

(56) Documents cités:
- EP-A2- 1 985 983
- DE-A1- 2 837 318
- US-A1- 2003 098 342
- US-A1- 2010 123 115
- US-B1- 6 452 475

## Description

La présente invention concerne le domaine des dispositifs électriques destinés à fonctionner à une température ambiante de fonctionnement élevée.

Une application préférée du dispositif électrique selon l'invention concerne la mesure à distance de grandeurs physiques, par exemple la mesure à distance de température, dans des environnements présentant une température ambiante élevée, à l'aide, en particulier, de capteurs de température à ondes élastiques de surface.

Il existe déjà dans l'état de la technique des dispositifs de ce type, dans lesquels les composants sont connectés entre eux par des techniques de sertissage. Ce type de connexion électrique présente l'inconvénient de ne pas pouvoir être utilisé sur des substrats de type monocristallins, tels que ceux employés par exemple, pour les capteurs de température à ondes de surface, lorsque la connexion électrique est soumise à des températures élevées, par exemple supérieure à 230°, voire supérieure à 500°C. Par ailleurs, ce type de connexion entraîne une liaison rigide entre les éléments du dispositif pouvant induire des effets de contraintes thermo-différentielles rédhibitoires pour l'intégrité du dispositif final.

La réalisation connue de connexions par des contacts de type pâte d'argent est également insatisfaisante en raison de pertes électriques trop importantes et d'une absence de résistance mécanique pour des températures supérieures à 500°C.

Par ailleurs, le document DE 28 37 318 A1 divulgue un dispositif électrique comprenant : un premier composant électrique ; un deuxième composant électrique ; et au moins une liaison électrique conductrice, reliant les premier et deuxième composants électriques et comportant :
un premier élément métallique ayant une première extrémité connectée électriquement au premier composant électrique et une deuxième extrémité ;
un deuxième élément métallique ayant une troisième extrémité connectée électriquement au deuxième composant électrique et une quatrième extrémité ; et
un moyen de connexion électrique ayant une plaque support électriquement isolante, et connectant la deuxième extrémité du premier élément métallique et la quatrième extrémité du deuxième élément métallique par un joint de soudure déposé sur la plaque support.

Le document US 2010/123115 A1 divulgue un dispositif électrique dans lequel deux composants électriques sont connectés l'un à l'autre par l'intermédiaire d'un matériau conducteur de l'électricité qui est liquide à la température de fonctionnement du dispositif électrique.

L'invention a pour objectif de proposer un dispositif électrique dont les composants sont connectés électriquement entre eux par un moyen de connexion électrique, utilisant des techniques alternatives à celles décrites ci-dessus, résistant à des températures élevées et adapté à la connexion de composants passifs, en particulier à ondes élastiques de surface, disposés sur des substrats de type monocristallins.

A cet effet, l'invention concerne un dispositif électrique et un procédé de fabrication d'un dispositif électrique selon les revendications.

L'invention sera mieux comprise à la lecture de la description qui va suivre, donnée uniquement à titre d'exemple et faite en se référant aux dessins annexés dans lesquels :
- la Figure 1 est une vue en coupe d'un premier exemple de mode de réalisation d'un dispositif électrique selon l'invention ;
- la Figure 2 est une vue de dessus d'un deuxième exemple de mode de réalisation d'un dispositif électrique selon l'invention ;
- la Figure 3 est une vue de dessus d'un exemple d'antenne faisant partie du dispositif électrique décrit dans la Figure 2 ;
- la Figure 4 est le tracé d'une courbe d'évolution du coefficient de réflexion de l'antenne décrite dans la Figure 2 en fonction de la fréquence ;
- la Figure 5 est une paire de deux courbes décrivant l'évolution de la partie réelle et de la partie imaginaire de l'admittance de l'antenne de la Figure 2 en fonction de la fréquence ;
- la Figure 6 est un diagramme de rayonnement de l'antenne décrite dans la Figure 2 ;
- la Figure 7 est un organigramme d'un procédé de fabrication d'un dispositif électrique décrit aux Figures 1 et 2 ; et
- la Figure 8 est un tracé d'une courbe de température en fonction du temps mesurée à l'aide d'un dispositif électrique selon l'invention.

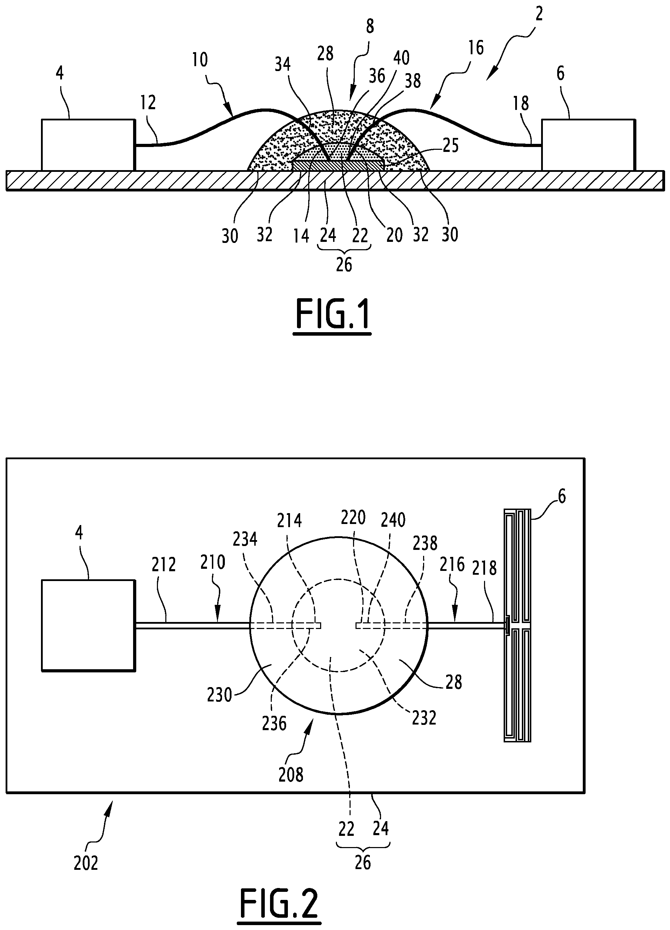

Suivant la Figure 1, un dispositif électrique 2, destiné à fonctionner à une température ambiante de fonctionnement élevée, notée Ta, comprend un capteur de température 4 et une antenne radioélectrique 6.

Le capteur de température 4 est, par exemple, un capteur de température à ondes élastiques de surface SAW (dénommé en anglais Surface Acoustic Wave sensor).

L'antenne radioélectrique 6 est, par exemple, reliée par liaison radioélectrique à un système d'interrogation à distance du capteur de température, externe au dispositif électrique 2, soumis à une température nettement inférieure à la température ambiante Ta, et non représenté sur la Figure 1.

De manière préférée, l'antenne radioélectrique 6 est constituée par un matériau compris dans l'ensemble formé par le chrome, le nickel, les alliages de chrome et de nickel, l'or, le cuivre, l'acier inoxydable, le titane, le platine, l'iridium, le molybdène, le zinc et le tungstène.

De façon générale, l'antenne radioélectrique est constituée par tout matériau présentant une température de fusion nettement inférieure à la température ambiante Ta.

L'antenne radioélectrique 6, est, par exemple, formée par des fils de cuivre multi-brins passivés et torsadés. Cette forme de réalisation de l'antenne radioélectrique 6 présente l'avantage de posséder une résistance mécanique remarquable.

Suivant la Figure 1, le capteur de température 4 et l'antenne radioélectrique 6 sont reliés mécaniquement et connectés électriquement par une liaison électrique 8 conductrice.

La liaison électrique 8 comprend un premier fil métallique 10 ayant une première extrémité 12 connectée au capteur de température 4 et présentant une deuxième extrémité 14, opposée à la première extrémité 12.

La liaison électrique 8 comprend en outre un deuxième fil métallique 16 présentant une troisième extrémité 18, reliée mécaniquement et électriquement à l'antenne radioélectrique 6, et présentant une quatrième extrémité 20 opposée à la troisième extrémité 18.

Les premier et deuxième fils métalliques sont, par exemple, constitués de platine ou d'or.

En variante, le premier fil métallique 10 et le deuxième fil métallique 16 sont des rubans de platine.

Suivant la Figure 1, la deuxième extrémité 14 du premier fil de platine 10 et la quatrième extrémité 20 du deuxième fil de platine 16 sont reliées par un joint de soudure 22 déposé sur une plaque d'alumine 24 au travers d'une couche mince adhésive 25, constituée, par exemple, d'un alliage de titane et de platine.

De manière préférée, le premier fil métallique 10 et le deuxième fil métallique 16 ont au moins une direction d'extension non contenue dans le plan d'extension de la plaque d'alumine 24.

Ainsi, le joint de soudure 22 permet de connecter électriquement le capteur de température 4 et l'antenne radioélectrique 6.

Ainsi, le joint de soudure 22 et la plaque d'alumine 24 forment un moyen de connexion électrique 26 du capteur de température 4 et de l'antenne radioélectrique 6.

Le joint de soudure 22 est, de façon classique, constitué par un matériau comprenant de l'étain. La température de fusion, notée Tf, du matériau constituant le joint de soudure est classiquement comprise entre 190°C et 250°C.

Dans l'ensemble de la présente description, une « température ambiante de fonctionnement élevée » est par définition une température ambiante Ta de fonctionnement du dispositif électrique 2, située dans une partie haute d'une plage de températures ambiantes de fonctionnement du dispositif électrique 2 et supérieure à la température de fusion Tf du joint de soudure 22.

Il est supposé que la température observée à la surface du joint de soudure exposée, c'est-à-dire la surface qui n'est pas en contact avec la plaque d'alumine 24, est sensiblement égale à la température ambiante de fonctionnement à quelques degrés près lorsque celle-ci règne dans l'environnement immédiat du dispositif électrique 2.

Il est à remarquer que cette définition de température ambiante de fonctionnement élevée autorise plusieurs configurations de plages de températures ambiantes de fonctionnement du dispositif électrique 2, une première configuration dans laquelle la température de fusion Tf du joint de soudure appartient à la plage, et une deuxième configuration dans laquelle la température de fusion Tf du joint de soudure n'appartient pas à la plage.

Ainsi, la température ambiante de fonctionnement élevée du dispositif électrique 2 est par définition supérieure à 190°C.

De manière préférée, la température ambiante de fonctionnement du dispositif électrique 2 est nettement supérieure à la température de fusion Tf du joint de soudure 22.

La température ambiante de fonctionnement du dispositif électrique 2 est, par exemple, supérieure à 600°C.

En outre, le joint de soudure 22 exposé, c'est-à-dire la surface du joint qui n'est pas en contact avec la plaque d'alumine 24, est recouvert dans sa totalité par un ciment 28.

Le ciment 28 est constitué en un matériau choisi imperméable au matériau du joint de soudure 22 lorsque la soudure se trouve à l'état liquide, et choisi adhésif par rapport à la plaque d'alumine 24 et aux premier et deuxième fils métalliques 10 et 16.

Le ciment 28 est, par exemple, une pâte céramique à base d'alumine, résistant à une température supérieure à la température ambiante de fonctionnement du dispositif électrique 2. Cette pâte présente des propriétés d'adhérence au platine remarquables.

Plus précisément, le ciment 28 recouvre et adhère à une première zone 30 de surface de la plaque d'alumine 24, périphérique et adjacente à une deuxième zone 32 de surface de la plaque d'alumine 24, la deuxième zone 32 correspondant à la zone de surface de la plaque d'alumine 24 recouverte par le joint de soudure 22.

De cette manière, le joint de soudure 22 est confiné de manière étanche dans le ciment 28 et maintenu mécaniquement en place sur la plaque d'alumine 24 par le ciment 28, même lorsqu'une température ambiante de fonctionnement du dispositif électrique 2, nettement supérieure à la température de fusion du joint de soudure 22, est appliquée au dispositif et que le joint de soudure 22 est alors à l'état liquide.

Suivant la Figure 1, le ciment 28 recouvre et adhère également à une troisième zone 34 de surface du premier fil métallique 10 adjacente à une quatrième zone 36 de surface du premier fil métallique 10. Les zones 34 et 36 de surface sont situées successivement le long de la deuxième extrémité 14 du premier fil métallique 10, la quatrième zone 36 correspondant à la zone de surface de la deuxième extrémité 14 du premier fil métallique 10 recouverte par le joint de soudure 22.

Suivant la Figure 1, le ciment 28 recouvre et adhère également à une cinquième zone 38 de surface du deuxième fil de platine 12 adjacente à une sixième zone 40 du deuxième fil de platine 12. Les zones 38 et 40 de surface sont situées successivement le long de la quatrième extrémité 20 du deuxième fil métallique 16, la sixième zone 40 correspondant à la zone de surface de la quatrième extrémité 20 du deuxième fil métallique 12 recouverte par le joint de soudure 22.

De cette manière, le ciment 28 assure le maintien mécanique des premier et deuxième fils métalliques 10 et 16 et empêche les premier et deuxième fils de quitter le joint de soudure 22 lorsque la température ambiante de fonctionnement du dispositif électrique 2, nettement supérieure à la température de fusion du joint de soudure 22, est appliquée au dispositif 2 et que le joint de soudure est alors à l'état liquide.

Ainsi, le ciment 28 permet d'assurer la liaison électrique entre le capteur de température 4 et l'antenne radioélectrique 6 lorsqu'une température ambiante de fonctionnement élevée est appliquée au dispositif électrique 2.

En d'autres termes, le ciment 28 permet d'assurer la liaison électrique entre le capteur de température 4 et l'antenne radioélectrique 6 indépendamment de l'état solide ou liquide du joint de soudure 22 et permet d'augmenter la plage des températures de fonctionnement du dispositif électrique vers des températures chaudes plus élevées.

En variante, le ciment 28 recouvre d'un seul tenant à la fois le capteur de température 4, l'antenne radioélectrique 6, les premier et deuxième fils métalliques 10 et 16 et le joint de soudure 22.

Suivant la Figure 2 et un deuxième exemple de mode de réalisation 202 d'un dispositif électrique selon l'invention, le dispositif électrique 202 comprend, à l'instar du dispositif électrique 2 de la Figure 1, un capteur de température 4, une antenne radioélectrique 6 et une plaque d'alumine 24, désignés par les mêmes références.

Le capteur de température 4 et l'antenne radioélectrique 6 sont fixés sur la plaque d'alumine 24 formant un substrat porteur.

A l'instar du dispositif électrique 2 de la Figure 1, l'antenne radioélectrique 6 est, par exemple, reliée par liaison radioélectrique à un système d'interrogation à distance du capteur de température non représenté.

Suivant la Figure 2, l'antenne radioélectrique 6 est une antenne planaire. Le capteur de température 4 et l'antenne planaire 6 sont reliés et connectés électriquement par une liaison électrique 208 conductrice.

La liaison électrique 208 comprend une première piste métallique 210 ayant une première extrémité 212 connectée au capteur de température 4 et présentant une deuxième extrémité 214 opposée à la première extrémité 212.

La liaison électrique 208 comprend en outre une deuxième piste métallique 216 présentant une troisième extrémité 218 reliée à l'antenne radioélectrique 6, et présentant une quatrième extrémité 220 opposée à la troisième extrémité 218.

Les première et deuxième pistes métalliques 210, 216 sont formées chacune d'une couche de métal, ici en cuivre, déposée et fixée sur la plaque d'alumine au travers d'une couche adhésive, ici en titane.

Suivant la Figure 2, la deuxième extrémité 214 de la première piste métallique 210 et la quatrième extrémité 220 de la deuxième piste métallique 216 sont reliées, à l'instar du dispositif de la Figure 1, par un joint de soudure 22 déposé sur la plaque d'alumine 24.

Ainsi, le joint de soudure 22 et la plaque d'alumine 24 forment un moyen de connexion électrique 26 du capteur de température 4 et de l'antenne radioélectrique 6.

En outre, le joint de soudure 22 est recouvert dans sa totalité par un ciment 28 identique à celui décrit à la Figure 1.

Plus précisément, le ciment 28 recouvre et adhère à une première zone 230 de surface de la plaque d'alumine 24, périphérique et adjacente à une deuxième zone 232 de surface de la plaque d'alumine 24, la deuxième zone 232 correspondant à la zone de surface de la plaque d'alumine 24 recouverte par le joint de soudure 22.

De cette manière, le joint de soudure 22 est confiné de manière étanche dans le ciment 28 et maintenu mécaniquement en place sur la plaque d'alumine 24 par le ciment 28, même lorsqu'une température ambiante de fonctionnement du dispositif électrique 202, nettement supérieure à la température de fusion Tf du joint de soudure 22, est appliquée au dispositif 202 et que le joint de soudure 22 est alors à l'état liquide.

Suivant la Figure 2, le ciment 28 recouvre et adhère également à une troisième zone 234 de surface de la première piste métallique 210 adjacente à une quatrième zone 236 de surface de la première piste métallique 210. Les zones 234 et 236 de surface sont situées successivement le long de la deuxième extrémité 214 de la première piste métallique 210, la quatrième zone 236 correspondant à la zone de surface de la deuxième extrémité 214 de la première piste 210 recouverte par le joint de soudure 22.

Suivant la Figure 2, le ciment 28 recouvre et adhère également à une cinquième zone 238 de surface de la deuxième piste métallique 216 adjacente à une sixième zone 240 de surface de la deuxième piste métallique 216. Les zones 238 et 240 sont situées successivement le long de la quatrième extrémité 220 de la deuxième piste métallique 216, la sixième zone 240 correspondant à la zone de surface de la quatrième extrémité 220 recouverte par le joint de soudure 22.

Du fait d'une bonne adhésion du ciment 28 sur les première et deuxième pistes 210, 216 en leurs respectives troisième et cinquième zones 234 et 238, des fuites de soudure liquide sont empêchées le long des première et deuxième pistes 210 et 216.

De cette manière, le ciment 28 assure l'étanchéité du joint de soudure 22 et le maintien de la connexion électrique 26, même lorsqu'une température ambiante de fonctionnement du dispositif électrique 202, nettement supérieure à la température de fusion du joint de soudure 22, est appliquée au dispositif 202 et que le joint de soudure 22 est alors à l'état liquide.

L'utilisation d'une première piste métallique et d'une deuxième piste métallique dans le dispositif électrique 202 permet de diminuer l'encombrement du dispositif électrique 202 en intégrant les éléments métalliques réalisés par les pistes dans ou sur la plaque d'alumine, ce qui facilite ainsi l'implantation d'autres composants.

L'utilisation d'une première piste métallique et d'une deuxième piste métallique intégrées dans la plaque d'alumine du dispositif électrique 202 diminue le risque de rupture ou d'arrachement hors du joint de soudure des éléments métalliques réalisés par les pistes planes, et/ou d'éviter le recours à des formes en boucle sur les éléments métalliques, permettant de compenser des effets de dilatation/raccourcissement des éléments métalliques.

En variante, le ciment 28 recouvre d'un seul tenant à la fois le capteur de température 4, l'antenne planaire 6, les pistes métalliques 210 et 216 et le joint de soudure 22. Cela permet d'accroître le maintien des éléments du dispositif électrique et des connexions électriques existant entre ces éléments.

En variante, les première et deuxième pistes métalliques 210 et 216 sont dépourvues de couche adhésive, le métal de la couche unique formant chacune des pistes étant choisi pour ses bonnes propriétés d'adhérence à la plaque d'alumine 24.

En variante, la couche adhésive est constituée par un matériau compris dans l'ensemble formé par le titane, l'oxyde de titane, le tantale, le chrome, le tungstène, le silicium,l'iridium, l'oxyde d'iridium, et l'aluminium dopé au cuivre, au titane ou au silicium.

De manière générale, la couche adhésive présente une épaisseur de quelques nanomètres à quelques dizaines de nanomètres.

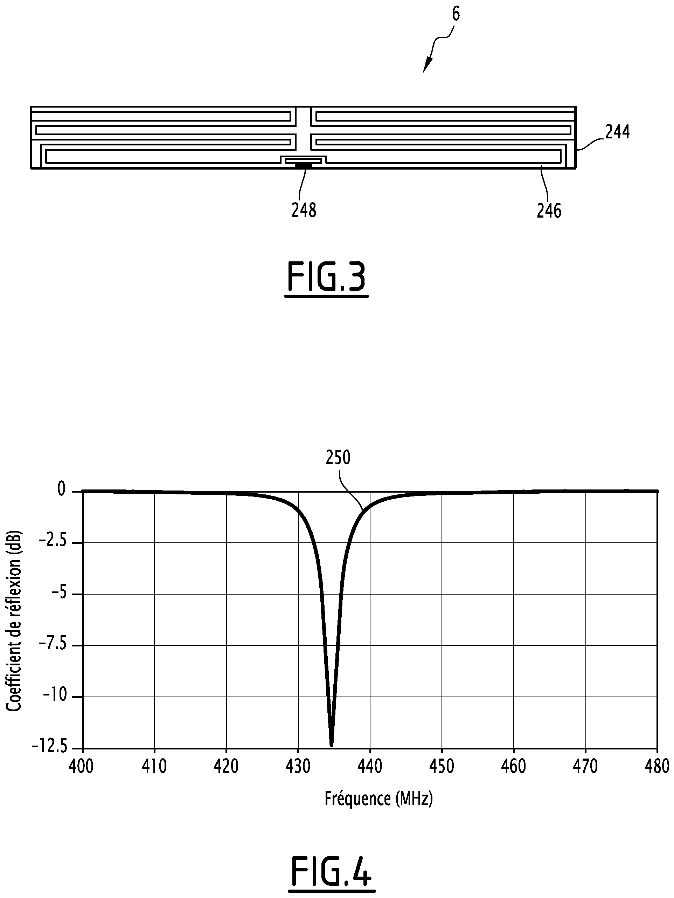

Sur la Figure 3, l'antenne radioélectrique 6 des dispositifs électriques 2, 202 décrits respectivement aux Figures 1 et 2 est par exemple une antenne de type planaire.

L'antenne radioélectrique planaire 6 comporte un substrat 244, par exemple en matériau céramique, par exemple de l'alumine, destiné à résister à la température ambiante Ta de fonctionnement élevée du dispositif électrique selon l'invention.

Sur le substrat 244 est imprimée une piste conductrice 246 avec des méandres formant un élément rayonnant.

L'antenne planaire 6 présente en outre un élément connecteur 248, permettant la connexion de l'antenne planaire 6 avec le capteur de température 4.

L'antenne planaire 6 présente une largeur sensiblement égale à 12 mm, une longueur sensiblement égale à 125 mm et une épaisseur sensiblement égale à 5 mm, pour un fonctionnement au voisinage de la bande ISM (Industrie-Scientifique-Médical) centrée en 434 MHz.

Ainsi, l'antenne planaire 6 présente l'avantage de posséder des dimensions réduites, notamment en terme de largeur et d'épaisseur, par rapport aux antennes quart d'onde court-circuitée plus communément appelée PIFA (de l'anglais « Planar Inverted-F Antenna »).

Sur la Figure 4, une courbe 250 représente l'évolution du coefficient de réflexion de l'antenne exprimé en dB en fonction de la fréquence exprimée en MHz lorsque l'antenne décrite dans la Figure 3 est adaptée au capteur de température dans son domaine de fonctionnement.

Ainsi, on voit sur la Figure 4 que l'antenne planaire décrite dans la Figure 3 est configurée pour fonctionner dans une bande de fréquences de fonctionnement comprise entre 430 MHz et 440 MHz, et présente un fonctionnement optimal à une fréquence sensiblement égale à 434 MHz.

La bande de fréquences de fonctionnement couvre une plage de dérives en fréquences de l'ordre de 7 à 8 MHz autour de la fréquence de fonctionnement optimale, les dérives étant induites par les variations de températures subies par le capteur de température, et correspondant à la plage de températures mesurées par le capteur.

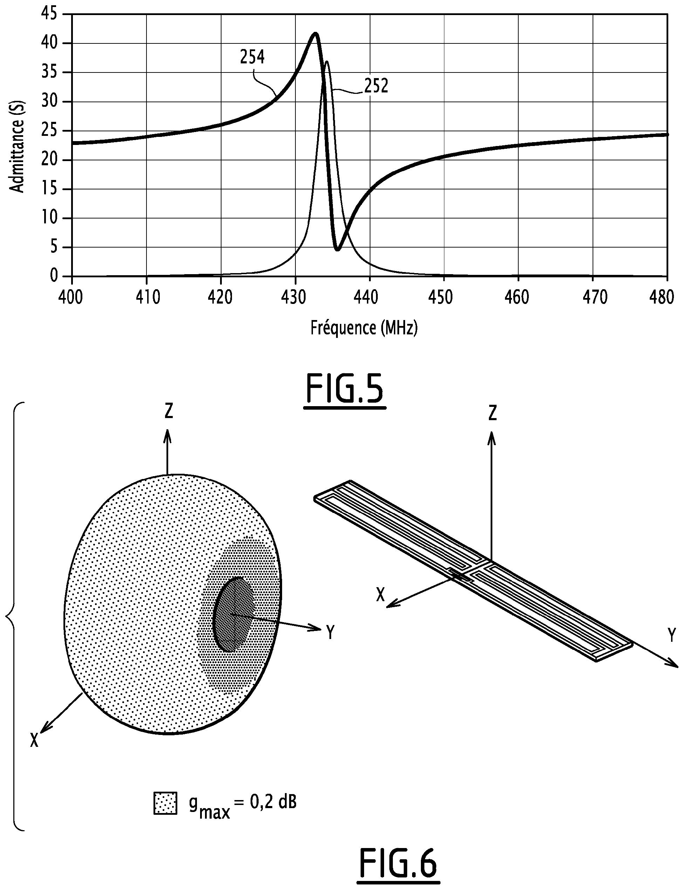

Suivant la Figure 5, la partie réelle de l'admittance de l'antenne planaire décrite dans la Figure 3 est représentée par la courbe 252, et la partie imaginaire de l'admittance d'entrée de cette antenne est représentée par la courbe 254.

Ainsi, on voit également sur la Figure 5 que l'antenne planaire telle que décrite dans la Figure 3 est apte à fonctionner dans une bande de fréquence comprise entre 430 MHz et 440 MHz.

L'antenne planaire telle que décrite dans la Figure 3 permet d'assurer un rayonnement des ondes radioélectriques représenté sur le diagramme de rayonnement de la Figure 6.

On voit sur le diagramme de rayonnement de la Figure 6 que l'antenne planaire telle que décrite dans la Figure 3 est conçue pour atteindre un gain maximum gₘₐₓ de 0.2 dB.

De manière générale, le dispositif électrique selon l'invention, destiné à fonctionner à une température ambiante de fonctionnement élevée, comprend un premier composant électrique, un deuxième composant électrique et au moins une liaison électrique conductrice, reliant les premier et deuxième composants électriques.

De manière générale, la liaison électrique comporte un premier élément métallique ayant une première extrémité connectée électriquement au premier composant électrique et une deuxième extrémité et un deuxième élément métallique ayant une troisième extrémité connectée électriquement au deuxième composant électrique et une quatrième extrémité.

Les premier et deuxième éléments métalliques sont par exemple des fils ou des rubans métalliques tels que décrits dans le premier mode de réalisation du dispositif électrique 2 décrit à la Figure 1.

Les premier et deuxième éléments métalliques sont par exemple des pistes métalliques déposées sur une plaque d'alumine telles que décrites dans le deuxième mode de réalisation du dispositif électrique 202 décrit à la Figure 2.

De manière générale, la liaison électrique comprend en outre un moyen de connexion électrique, ayant une plaque support électriquement isolante, et connectant la deuxième extrémité du premier élément métallique et la quatrième extrémité du deuxième élément métallique par un joint de soudure déposé sur la plaque support, le joint de soudure possédant une température de fusion nettement inférieure à la température de fonctionnement du dispositif électrique.

De manière générale, au moins l'un des premier et deuxième composants électriques, et la ou chaque liaison électrique sont destinées à fonctionner à une température ambiante de fonctionnement élevée.

De manière générale, le dispositif électrique comprend un ciment déposé pour recouvrir dans sa totalité le joint de soudure exposé, et pour recouvrir en y adhérant une première zone de surface de la plaque support adjacente à une deuxième zone de la plaque support en contact avec le joint de soudure, une troisième zone de surface du premier élément métallique adjacente à une quatrième zone de surface du premier élément métallique incluse dans le joint de soudure, et une cinquième zone de surface du deuxième élément métallique adjacente à une sixième zone de surface du deuxième élément métallique incluse dans le joint de soudure, le matériau du ciment étant choisi pour maintenir son adhésion sur la première zone, la troisième zone et la cinquième zone et son étanchéité vis-à-vis du joint de soudure lorsque la température de fonctionnement ambiante est appliquée au dispositif électrique.

De manière préférée, les premier et deuxième composants électriques sont disposés sur la plaque support du moyen de connexion électrique.

En variante, les premier et deuxième composants électriques sont disposés sur une ou deux plaques, différentes de la plaque support du moyen de connexion électrique, ce qui permet une implantation d'un ou des deux composants électriques par rapport au moyen de connexion électrique.

En variante, le ciment recouvre d'un seul tenant à la fois le premier composant électrique, le deuxième composant électrique, le premier élément métallique, le deuxième élément métallique et le joint de soudure.

De manière préférée, les premier et deuxième éléments métalliques sont constitués en un matériau compris dans l'ensemble formé par le platine, le tungstène, l'iridium, l'or, le nickel, le cuivre et le molybdène.

De façon générale, les premier et deuxième éléments métalliques sont constitués par tout métal présentant une température de fusion inférieure à la température ambiante Ta.

De manière préférée, la plaque support est constituée dans un matériau compris dans l'ensemble formé par l'alumine, le zircone, le nitrure d'aluminium, et le nitrure de gallium polycristallin.

De manière générale, la plaque support est constituée par tout matériau non conducteur présentant une température de fusion nettement supérieure à la température ambiante Ta.

De manière préférée également, le ciment est constitué dans un matériau compris dans l'ensemble formé par les pâtes céramiques à base d'alumine et les pâtes céramiques à base de flocons d'argent.

De façon générale, le ciment est constitué par toute pâte céramique qui, une fois recuite et conditionnée, présente une température de fusion nettement supérieure à la température ambiante Ta.

De manière générale, le premier composant électrique est compris dans l'ensemble formé par les oscillateurs, les filtres, les capteurs de température et/ou de pressions, les capteurs de contrainte, et les capteurs de grandeurs physico-chimiques réalisés à partir de transducteurs piézoélectriques à ondes élastiques de surfaces ou à ondes élastiques de volume ou à vibrations localisées.

De manière générale, le deuxième composant électrique est compris dans l'ensemble formé par les oscillateurs, les filtres, les capteurs de température et/ou de pressions, les capteurs de contrainte, les capteurs de grandeurs physico-chimiques réalisés à partir de transducteurs piézoélectriques à ondes surfaces, à ondes de volume ou à vibrations localisées et les antennes radioélectriques.

En particulier, le premier composant électrique est un capteur de température à ondes de surface, et le deuxième composant électrique est une antenne radioélectrique, l'antenne radioélectrique étant constituée par un matériau compris dans l'ensemble formé par le chrome, le nickel, les alliages de chrome et de nickel, l'or, le cuivre, l'acier inoxydable, le platine, l'iridium et le molybdène.

De façon générale, l'antenne radioélectrique est constituée par tout métal présentant une température de fusion nettement inférieure à la température ambiante Ta.

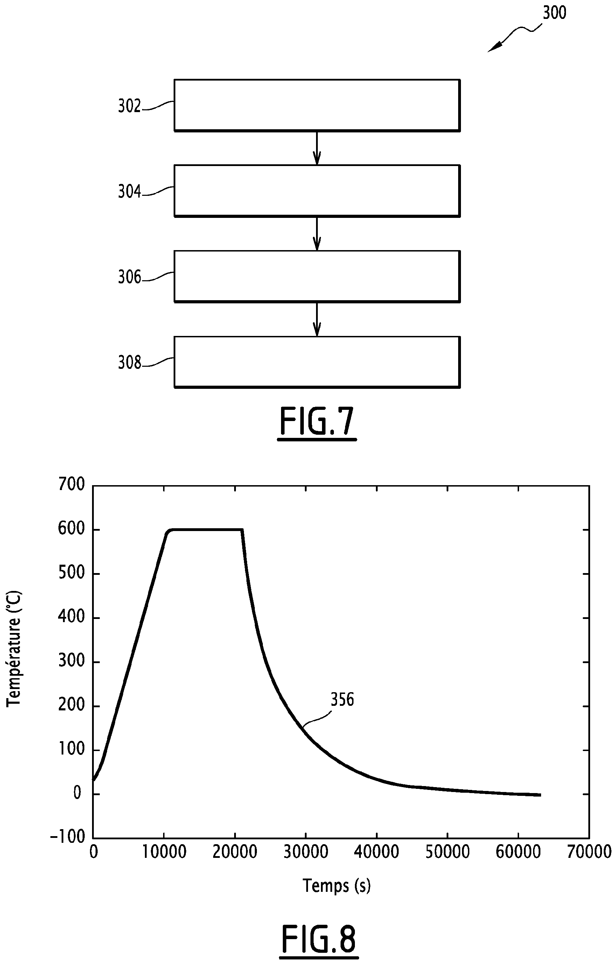

Suivant la Figure 7, un procédé 300 de fabrication d'un dispositif électrique 2, 202, destiné à fonctionner à une température ambiante de fonctionnement élevée décrit dans les Figures 1 et 2 comprend les étapes suivantes mises en oeuvre successivement.

Dans une première étape 302, un premier composant électrique 4, un deuxième composant électrique 6, et une plaque support 24 électriquement isolante sont fournis.

Dans une deuxième étape 304, un premier élément métallique 10, 210 ayant une première extrémité 12, 212 connectée électriquement au premier composant électrique 4 et une deuxième extrémité 14, 214, et un deuxième élément métallique 16, 216 ayant une troisième extrémité 18, 218 connectée électriquement au deuxième composant électrique 6 et une quatrième extrémité 20, 220 sont fournis.

Dans le procédé de fabrication du dispositif électrique 202 décrit dans la Figure 2, l'étape 304 de fourniture des premier et deuxième éléments métalliques 210 et 216 comporte, de manière préférée :
- une étape de dépôt d'une première couche adhésive et d'une deuxième couche adhésive sur la plaque support 24 sous la forme d'une première piste et d'une deuxième piste ;
- une étape de dépôt des premier et deuxième éléments métalliques 210 et 216 respectivement sur la première piste et sur la deuxième piste, de façon à former respectivement une première piste métallique et une deuxième piste métallique.

Dans une troisième étape 306, la deuxième extrémité 14, 214 du premier élément métallique 10, 210 et la quatrième extrémité 20, 220 du deuxième élément métallique 16, 216 sont connectées par un joint de soudure 22 déposé sur la plaque support 24, le joint de soudure 22 possédant une température de fusion Tf nettement inférieure à la température ambiante de fonctionnement Ta du dispositif électrique 2, 202.

Dans une quatrième étape 308, un ciment 28 est déposé de façon à recouvrir dans sa totalité le joint de soudure 22 exposé, à recouvrir et à adhérer à une première zone 30, 230 de surface de la plaque support 24 adjacente à une deuxième zone 32, 232 de la plaque support 24 en contact avec le joint de soudure 22, à une troisième zone 34, 234 de surface du premier élément métallique 10, 210 adjacente à une quatrième zone 36, 236 de surface du premier élément métallique 10, 210 incluse dans le joint de soudure 22, et à une cinquième zone 38, 238 de surface du deuxième élément métallique 16, 216 adjacente à une sixième zone 40, 240 de surface du deuxième élément métallique 16, 216 incluse dans le joint de soudure 22, le matériau du ciment 28 étant choisi pour maintenir son adhésion sur la première zone 30, 230, la troisième zone 34, 234 et la cinquième zone 38, 238 et son étanchéité vis-à-vis du joint de soudure 22 lorsque la température ambiante Ta de fonctionnement est appliquée au dispositif électrique 2, 202.

Suivant la Figure 8, une courbe 356 représente l'évolution temporelle d'une mesure de température ambiante élevée d'un environnement, la mesure étant effectuée à l'aide d'un dispositif électrique, constituant une variante du dispositif électrique 2 selon l'invention décrit à la Figure 1. Ici on cherche à valider seulement le fonctionnement de l'au moins un moyen de connexion électrique selon de l'invention.

Le dispositif électrique de mesure permettant d'obtenir la courbe 356 comprend une sonde de température PT100 formant un premier composant électrique, et un multimètre numérique formant un deuxième composant électrique. La sonde PT100 et le multimètre numérique sont connectés électriquement sur une même plaque d'alumine par des première et deuxième liaisons électriques analogues chacune à celle décrite à la Figure 1.

La plaque d'alumine sert de support à la sonde de température PT100. La sonde est peu éloignée des premier et deuxième moyens de connexion électrique respectivement associés et appartenant aux première et deuxième liaisons électriques.

La sonde de température PT100 et les deux moyens de connexion électrique sont soumis à un environnement thermique de température élevée en étant placés dans une étuve tandis que le multimètre numérique, disposé à l'extérieur de l'étuve, est soumis à une température peu élevée, par exemple de l'ordre de 25°C.

Les première et deuxième liaisons électriques comprennent chacune un premier fil métallique différent, relié selon une première extrémité à une polarité différente de la sonde de température PT100, et un deuxième fil en cuivre différent, relié à une borne différente du multimètre numérique.

Les premier et deuxième moyens de connexion électrique connectent respectivement les premiers et deuxièmes fils métalliques correspondant respectivement aux première et deuxième liaisons électriques par un premier joint et un deuxième joint de soudure, les joints de soudure étant séparés entre eux.

Un ciment recouvre globalement et en totalité les deux moyens de connexion électrique contenant les deux joints de soudures, les deux premiers fils métalliques et la sonde de température PT100.

La sonde de température et les moyens de connexion électrique, disposés dans l'étuve, subissent un cycle de température prédéterminé. Le multimètre numérique, placé à l'extérieur de l'étuve et relié à la sonde au travers des deuxièmes fils de cuivre acquiert les mesures de température et les envoie sous forme de données à un ordinateur. L'ordinateur met en forme les données et fournit alors la courbe 356.

Sur la courbe 356, on peut observer d'une part la qualité de la mesure de température, le dispositif électrique se révélant opérationnel durant plus de 4 heures à des températures supérieures à 500°C, et d'autre part l'absence de perturbation due à la fusion du joint de soudure 22.

Ainsi, lorsqu'une température ambiante de fonctionnement élevée est appliquée au moyen de connexion électrique, la liaison électrique entre le premier composant et le deuxième composant est maintenue malgré la fusion du joint de soudure. Le ciment permet de garantir la cohérence mécanique du premier élément métallique, du deuxième élément métallique et du joint de soudure, malgré la fusion du joint de soudure, et permet de ce fait de maintenir la liaison électrique entre le premier composant électrique et le deuxième composant électrique.

Une application préférée du dispositif électrique selon l'invention concerne la mesure à distance de grandeurs physiques, par exemple la mesure à distance de température, dans des environnements présentant une température ambiante élevée, à l'aide de capteurs de température passifs, par exemple à ondes élastiques de surface ou de volume.

## Revendications

1. Dispositif électrique (2, 202) destiné à fonctionner à une température ambiante de fonctionnement (Ta) élevée, c'est-à-dire supérieure à 190°C, de préférence supérieure à 250°C, de préférence encore supérieure à 600°, comprenant :
un premier composant électrique (4) ;
un deuxième composant électrique (6) ; et
au moins une liaison électrique (8) conductrice, reliant les premier et deuxième composants électriques (4, 6) comportant :
- un premier élément métallique (10, 210) ayant une première extrémité (12, 212) connectée électriquement au premier composant électrique (4) et une deuxième extrémité (14, 214) ;
- un deuxième élément métallique (16, 216) ayant une troisième extrémité (18, 218) connectée électriquement au deuxième composant électrique (6) et une quatrième extrémité (20, 220) ; et
- un moyen de connexion électrique (26), ayant une plaque support (24) électriquement isolante, et connectant la deuxième extrémité (16, 216) du premier élément métallique (10, 210) et la quatrième extrémité (20, 220) du deuxième élément métallique (16 , 216) par un joint de soudure (22) déposé sur la plaque support (24), le joint de soudure (22) possédant une température de fusion (Tf) inférieure à la température ambiante de fonctionnement (Ta) du dispositif électrique (2, 202) ;
au moins l'un des premier et deuxième composants électriques (4, 6), et la ou chaque liaison électrique (8) étant destinés à fonctionner à ladite température ambiante de fonctionnement (Ta) ;
**caractérisé en ce que** le dispositif électrique (2, 202) comprend :
un ciment (28) déposé pour recouvrir dans sa totalité le joint de soudure (22) exposé, et pour recouvrir en y adhérant une première zone (30, 230) de surface de la plaque support (24) adjacente à une deuxième zone (32, 232) de la plaque support (24) en contact avec le joint de soudure (22), une troisième zone (34, 234) de surface du premier élément métallique (10, 210) adjacente à une quatrième zone (36, 236) de surface du premier élément métallique (10, 210) incluse dans le joint de soudure (22), et une cinquième zone (38, 238) de surface du deuxième élément métallique (16, 216) adjacente à une sixième zone (40, 240) de surface du deuxième élément métallique (16, 216) incluse dans le joint de soudure (22), le matériau du ciment (28) étant choisi pour maintenir son adhésion sur la première zone (30, 230), la troisième zone (34, 234) et la cinquième zone (38, 238) et son étanchéité vis-à-vis du joint de soudure (22) lorsque la température ambiante de fonctionnement est appliquée au dispositif électrique (2, 202).

2. Dispositif électrique (2, 202) selon la revendication 1, dans lequel les premier et deuxième composants électriques (4, 6) sont disposés sur la plaque support (24) du moyen de connexion électrique (26).

3. Dispositif électrique (2, 202) selon la revendication 2, dans lequel le ciment (28) recouvre d'un seul tenant à la fois le premier composant électrique (4), le deuxième composant électrique (6), le premier élément métallique (10, 210), le deuxième élément métallique (16, 216) et le joint de soudure (22).

4. Dispositif électrique (2, 202) selon l'une quelconque des revendications 1 à 3, dans lequel le premier élément métallique (10, 210) et le deuxième élément métallique (16, 216) sont chacun un fil métallique ou un ruban métallique différent ayant au moins une direction d'extension non contenue dans le plan d'extension de la plaque support (24).

5. Dispositif électrique (2, 202) selon l'une quelconque des revendications 1 à 3, dans lequel le premier élément métallique (10, 210) et le deuxième élément métallique (16, 216) sont chacun une piste métallique différente disposée sur la plaque support (24).

6. Dispositif électrique (2, 202) selon la revendication 5, comprenant une couche adhésive (25) disposée entre chacune des pistes métalliques formant les premier et deuxième éléments métalliques (10, 210, 16, 216) et la plaque support (24).

7. Dispositif électrique (2, 202) selon la revendication 6, **caractérisé en ce que** la couche adhésive (25) est constituée par un matériau compris dans l'ensemble formé par le titane, l'oxyde de titane, le tantale, le chrome, le tungstène, le silicium, l'iridium, l'oxyde d'iridium, et l'aluminium dopé au cuivre, au titane ou au silicium.

8. Dispositif électrique (2, 202) selon l'une quelconque des revendications 1 à 7, dans lequel les premier et deuxième éléments métalliques (10, 210, 16, 216) sont constitués en un matériau compris dans l'ensemble formé par le platine, le tungstène, l'iridium, l'or, le nickel, le cuivre et le molybdène ; la plaque support (24) est constituée dans un matériau compris dans l'ensemble formé par l'alumine, le zircone, le nitrure d'aluminium et le nitrure de gallium polycristallin, et le ciment (28) est constitué dans un matériau compris dans l'ensemble formé par les pâtes céramiques à base d'alumine et les pâtes céramiques à base de flocons d'argent.

9. Dispositif électrique (2, 202) selon l'une quelconque des revendications 1 à 8, dans lequel le premier composant électrique (4) est compris dans l'ensemble formé par les oscillateurs, les filtres, les capteurs de température et/ou de pressions, les capteurs de contrainte, les capteurs de grandeurs physico-chimiques réalisés à partir de transducteurs piézoélectriques à ondes élastiques de surfaces ou à ondes élastiques de volume ou à vibrations localisées ; et le deuxième composant électrique est compris dans l'ensemble formé par les oscillateurs, les filtres, les capteurs de température et/ou de pressions, les capteurs de contrainte, les capteurs de grandeurs physico-chimiques réalisés à partir de transducteurs piézoélectriques à ondes surfaces, à ondes de volume ou à vibrations localisées et les antennes radioélectriques.

10. Dispositif électrique (2, 202) selon l'une quelconque des revendications 1 à 9, dans lequel le premier composant électrique (4) est un capteur de température à ondes de surface, et le deuxième composant électrique (6) est une antenne radioélectrique, l'antenne radioélectrique étant constituée par un matériau compris dans l'ensemble formé par le chrome, le nickel, les alliages de chrome et de nickel, l'or, le cuivre, l'acier inoxydable, le titane, le platine, l'iridium, le molybdène, le zinc, le tungstène.

11. Procédé (300) de fabrication d'un dispositif électrique (2, 202) destiné à fonctionner à une température ambiante de fonctionnement élevée, c'est-à-dire supérieure à 190°C, de préférence supérieure à 250°C, de préférence encore supérieure à 600° comprenant :
- une étape (302) de fourniture d'un premier composant électrique (4), d'un deuxième composant électrique (6), et d'une plaque support (24) électriquement isolante ;
- une étape (304) de fourniture d'un premier élément métallique (10, 210) ayant une première extrémité (12, 212) connectée électriquement au premier composant électrique (4) et une deuxième extrémité (14, 214), et d'un deuxième élément métallique (16, 216) ayant une troisième extrémité (18, 218) connectée électriquement au deuxième composant électrique (6) et une quatrième extrémité (20, 220) ; et
- une étape de connexion (306) de la deuxième extrémité (14, 214) du premier élément métallique (10, 210) et de la quatrième extrémité (20, 220) du deuxième élément métallique (16, 216) par un joint de soudure (22) déposé sur la plaque support (24), le joint de soudure (22) possédant une température de fusion (Tf) inférieure à la température ambiante de fonctionnement (Ta) du dispositif électrique (2, 202) ;
**caractérisé en ce que** le procédé comprend une étape (308) consistant à déposer un ciment (28) de façon à recouvrir dans sa totalité le joint de soudure (22) exposé, à recouvrir et à adhérer à une première zone (30, 230) de surface de la plaque support (24) adjacente à une deuxième zone (32, 232) de la plaque support (24) en contact avec le joint de soudure (22), à une troisième zone (34, 234) de surface du premier élément métallique (10, 210) adjacente à une quatrième zone (36, 236) de surface du premier élément métallique (10, 210) incluse dans le joint de soudure (22), et à une cinquième zone (38, 238) de surface du deuxième élément métallique (16, 216) adjacente à une sixième zone (40, 240) de surface du deuxième élément métallique (16, 216) incluse dans le joint de soudure (22), le matériau du ciment (28) étant choisi pour maintenir son adhésion sur la première zone (30, 230), la troisième zone (34, 234) et la cinquième zone (38, 238) et son étanchéité vis-à-vis du joint de soudure (22) lorsque la température ambiante de fonctionnement est appliquée au dispositif électrique (2, 202).

12. Procédé de fabrication d'un dispositif électrique (2, 202) selon la revendication 11, **caractérisé en ce que** l'étape (304) de fourniture des premier et deuxième éléments métalliques (10, 210, 16, 216) comporte les étapes suivantes :
- déposer une première couche adhésive et une deuxième couche adhésive sur la plaque support (24) sous la forme d'une première piste et d'une deuxième piste ;
- déposer les premier et deuxième éléments métalliques (10, 210, 16, 216) respectivement sur la première piste et sur la deuxième piste, de façon à former respectivement une première piste métallique et une deuxième piste métallique.

## Patentansprüche

1. Elektrische Vorrichtung (2, 202), die dazu bestimmt ist, bei einer erhöhten Arbeits-Umgebungstemperatur (Ta) zu arbeiten, das heißt bei höher als 190°C, bevorzugt höher als 250°C und noch bevorzugter höher als 600°C, aufweisend:
eine erste elektrische Komponente (4),
eine zweite elektrische Komponente (6) und
wenigstens eine elektrische, leitende Verbindung (8), die die erste und die zweite elektrische Komponente (4, 6) verbindet und die aufweist:
- ein erstes metallisches Element (10, 210), das ein erstes Ende (12, 212), das elektrisch mit der ersten elektrischen Komponente (4) verbunden ist, und ein zweites Ende (14, 214) hat,
- ein zweites metallisches Element (16, 216), das ein drittes Ende (18, 218), das elektrisch mit der zweiten elektrischen Komponente (6) verbunden ist, und ein viertes Ende (20, 220) hat, und
- ein Mittel zur elektrischen Verbindung (26), das eine elektrisch isolierende Halteplatte (24) hat und das das zweite Ende (16, 216) des ersten metallischen Elements (10, 210) und das vierte Ende (20, 220) des zweiten metallischen Elements (16, 216) über eine Lötverbindung (22) verbindet, die auf der Halteplatte (24) angeordnet ist, wobei die Lötverbindung (22) eine Schmelztemperatur (Tf) hat, die kleiner ist als die Arbeits-Umgebungstemperatur (Ta) der elektrischen Vorrichtung (2, 202),
wobei wenigstens eine der ersten und der zweiten elektrischen Komponente (4, 6) und die oder jede elektrische Verbindung (8) dazu bestimmt sind, bei der Arbeits-Umgebungstemperatur (Ta) zu arbeiten,
**dadurch gekennzeichnet, dass** die elektrische Vorrichtung (2, 202) aufweist:
einen Zement (28), der angeordnet ist zum Abdecken der exponierten Lötverbindung (22) in deren Gesamtheit und zum Abdecken, unter daran Haften, eines ersten Bereichs (30, 230) der Oberfläche der Halteplatte (24) benachbart zu einem zweiten Bereich (32, 232) der Halteplatte (24), der in Kontakt mit der Lötverbindung (22) ist, eines dritten Bereichs (34, 234) der Oberfläche des ersten metallischen Elements (10, 210) benachbart zu einem vierten Bereich (36, 236) der Oberfläche des ersten metallischen Elements (10, 210), der in der Lötverbindung (22) eingeschlossen ist, und eines fünften Bereichs (38, 238) der Oberfläche des zweiten metallischen Elements (16, 216) benachbart zu einem sechsten Bereich (40, 240) der Oberfläche des zweiten metallischen Elements (16, 216), der in der Lötverbindung (22) eingeschlossen ist, wobei das Material des Zements (28) ausgewählt ist zum Aufrechterhalten dessen Anhaftung am ersten Bereich (30, 230), am dritten Bereich (34, 234) und am fünften Bereich (38, 238) und dessen Dichtheit gegenüber der Lötverbindung (22), wenn die Arbeits-Umgebungstemperatur auf die elektrische Vorrichtung (2, 202) angewandt wird.

2. Elektrische Vorrichtung (2, 202) gemäß Anspruch 1, wobei die erste und die zweite elektrische Komponente (4, 6) auf der Halteplatte (24) des Mittels zur elektrischen Verbindung (26) angeordnet sind.

3. Elektrische Vorrichtung (2, 202) gemäß Anspruch 2, wobei der Zement (28) in einem Stück zugleich die erste elektrische Komponente (4), die zweite elektrische Komponente (6), das erste metallische Element (10, 210), das zweite metallische Element (16, 216) und die Lötverbindung (22) abdeckt.

4. Elektrische Vorrichtung (2, 202) gemäß irgendeinem der Ansprüche 1 bis 3, wobei das erste metallische Element (10, 210) und das zweite metallische Element (16, 216) jeweils ein unterschiedlicher metallischer Draht oder ein unterschiedliches metallisches Band sind, der/das wenigstens eine Erstreckungsrichtung hat, die nicht in der Erstreckungsebene der Halteplatte (24) liegt.

5. Elektrische Vorrichtung (2, 202) gemäß irgendeinem der Ansprüche 1 bis 3, wobei das erste metallische Element (10, 210) und das zweite metallische Element (16, 216) jeweils eine unterschiedliche metallische Bahn sind, die auf der Halteplatte (24) angeordnet ist.

6. Elektrische Vorrichtung (2, 202) gemäß Anspruch 5, aufweisend eine Klebeschicht (25), die zwischen jeder der metallischen Bahnen, welche das erste und das zweite metallische Element (10, 210, 16, 216) bilden, und der Halteplatte (24) angeordnet ist.

7. Elektrische Vorrichtung (2, 202) gemäß Anspruch 6, **dadurch gekennzeichnet, dass** die Klebeschicht (25) aus einem Material gebildet ist, das in die Gruppe fällt, die gebildet ist aus Titan, Titanoxid, Tantal, Chrom, Wolfram, Silizium, Iridium, Iridium-Oxid und Kupfer-, Titan- oder Silizium-dotiertes Aluminium.

8. Elektrische Vorrichtung (2, 202) gemäß irgendeinem der Ansprüche 1 bis 7, wobei das erste und das zweite metallische Element (10, 210, 16, 216) gebildet sind aus einem Material, das in die Gruppe fällt, die gebildet ist aus Platin, Wolfram, Iridium, Gold, Nickel, Kupfer und Molybdän, wobei die Halteplatte (24) gebildet ist aus einem Material, das in die Gruppe fällt, die gebildet ist aus Aluminium, Zirkonium, Aluminiumnitrid und polykristallinem Gallium-Nitrid, und wobei der Zement (28) gebildet ist aus einem Material, das in die Gruppe fällt, die gebildet ist aus keramischen Pasten auf Aluminiumoxidbasis und keramischen Pasten auf Silberschrotbasis.

9. Elektrische Vorrichtung (2, 202) gemäß irgendeinem der Ansprüche 1 bis 8, wobei die erste elektrische Komponente (4) in die Gruppe fällt, die gebildet ist aus Oszillatoren, Filtern, Temperatur- und/oder Druck-Sensoren, Spannungs-Sensoren, Sensoren physio-chemischer Größen, die realisiert sind ausgehend von piezoelektrischen Wandlern von elastischen Oberflächenwellen oder elastischen Raumwellen oder von örtlich begrenzten Vibrationen, und wobei die zweite elektrische Komponente in die Gruppe fällt, die gebildet ist aus Oszillatoren, Filtern, Temperatur- und/oder Druck-Sensoren, Spannungs-Sensoren, Sensoren physio-chemischer Größen, die realisiert sind ausgehend von piezoelektrischen Wandlern von Oberflächenwellen, von Raumwellen oder von örtlich begrenzten Vibrationen und radioelektrischen Antennen.

10. Elektrische Vorrichtung (2, 202) gemäß irgendeinem der Ansprüche 1 bis 9, wobei die erste elektrische Komponente (4) ein Oberflächenwellen-Temperatursensor ist und die zweite elektrische Komponente (6) eine radioelektrische Antenne ist, wobei die radioelektrische Antenne gebildet ist aus einem Material, das in die Gruppe fällt, die gebildet ist aus Chrom, Nickel, Chrom-Nickel-Legierungen, Gold, Kupfer, nichtrostendem Stahl, Titan, Platin, Iridium, Molybdän, Zink, Wolfram.

11. Verfahren (300) zur Herstellung einer elektrischen Vorrichtung (2, 202), die dazu bestimmt ist, bei einer erhöhten Arbeits-Umgebungstemperatur zu arbeiten, das heißt bei höher als 190°C, bevorzugt höher als 250°C, noch bevorzugter höher als 600°C, aufweisend:
- einen Schritt (302) des Bereitstellens einer ersten elektrischen Komponente (4), einer zweiten elektrischen Komponente (6) und einer elektrisch isolierenden Halteplatte (24),
- einen Schritt (304) des Bereitstellens eines ersten metallischen Elements (10, 210), das ein erstes Ende (12, 212), das elektrisch mit einer ersten elektrischen Komponente (4) verbunden ist, und ein zweites Ende (14, 214) hat, und eines zweiten metallischen Elements (16, 216), das ein drittes Ende (18, 218), das elektrisch mit der zweiten elektrischen Komponente (6) verbunden ist, und ein viertes Ende (20, 220) hat, und
- einen Schritt des Verbindens (306) des zweiten Endes (14, 214) des ersten metallischen Elements (10, 210) und des vierten Endes (20, 220) des zweiten metallischen Elements (16, 216) durch eine Lötverbindung (22), die auf der Halteplatte (24) angeordnet ist, wobei die Lötverbindung (22) eine Schmelztemperatur (Tf) hat, die kleiner ist als die Arbeits-Umgebungstemperatur (Ta) der elektrischen Vorrichtung (2, 202),
**dadurch gekennzeichnet, dass** das Verfahren aufweist einen Schritt (308), der besteht aus Anordnen eines Zements (28), um die exponierte Lötverbindung (22) in deren Gesamtheit abzudecken und um abzudecken und anzuhaften an einem ersten Bereich (30, 230) der Oberfläche der Halteplatte (24), der benachbart ist zu einem zweiten Bereich (32, 232) der Halteplatte (24), der in Kontakt mit der Lötverbindung (22) ist, einem dritten Bereich (34, 234) der Oberfläche des ersten metallischen Elements (10, 210), der benachbart ist zu einem vierten Bereich (36, 236) der Oberfläche des ersten metallischen Elements (10, 210), der in der Lötverbindung (22) eingeschlossen ist, und einem fünften Bereich (38, 238) der Oberfläche des zweiten metallischen Elements (16, 216), der benachbart ist zu einem sechsten Bereich (40, 240) der Oberfläche des zweiten metallischen Elements (16, 216), der in der Lötverbindung (22) eingeschlossen ist, wobei das Material des Zements (28) ausgewählt ist zum Aufrechtrechterhalten dessen Anhaftens an dem ersten Bereich (30, 230), dem dritten Bereich (34, 234) und dem fünften Bereich (38, 238) und dessen Dichtheit gegenüber der Lötverbindung (22), wenn die Arbeits-Umgebungstemperatur auf die elektrische Vorrichtung (2, 202) angewandt wird.

12. Verfahren zur Herstellung einer elektrischen Vorrichtung (2, 202) gemäß Anspruch 11, **dadurch gekennzeichnet, dass** der Schritt (304) des Bereitstellens des ersten und des zweiten elektrischen Elements (10, 210, 16, 216) die folgenden Schritte aufweist:
- Anordnen einer ersten Klebeschicht und einer zweiten Klebeschicht auf der Halteplatte (24) in der Form einer ersten Bahn und einer zweiten Bahn,
- Anordnen des ersten und des zweiten metallischen Elements (10, 210, 16, 216) respektive auf der ersten Bahn und auf der zweiten Bahn, um respektive eine erste metallische Bahn und eine zweite metallische Bahn zu bilden.

## Claims

1. An electrical device (2, 202) designed to operate at a high ambient operating temperature (Ta), i.e. above 190°C, preferably above 250°C, more preferably above 600°C, comprising:
a first electrical component (4);
a second electrical component (6); and
at least one conductive electrical connection (8), connecting the first and second electrical components (4, 6), including:
- a first metal element (10, 210) having a first end (12, 212) electrically connected to the first electrical component (4) and a second end (14, 214);
- a second metal element (16, 216) having a third end (18, 218) electrically connected to the second electrical component (6) and a fourth end (20, 220); and
- an electrical connection means (26), having an electrically insulating support plate (24), and connecting the second end (16, 216) of the first metal element (10, 210) and the fourth end (20, 220) of the second metal element (16, 216) by a weld joint (22) deposited on the support plate (24), the weld joint (22) having a melting temperature (Tf) lower than the ambient operating temperature (Ta) of the electrical device (2, 202);
at least one of the first and second electrical components (4, 6) and the or each electrical connection (8) being designed to operate at said ambient operating temperature (Ta);
**characterized in that** the electrical device (2, 202) comprises:
a cement (28) deposited to cover the entire exposed weld joint (22), and to cover, while adhering thereto, a first surface zone (30, 230) of the support plate (24) adjacent to a second zone (32, 232) of the support plate (24) in contact with the weld joint (22), a third surface zone (34, 234) of the first metal element (10, 210) adjacent to a fourth surface zone (36, 236) of the first metal element (10, 210) included in the weld joint (22), and a fifth surface zone (38, 238) of the second metal element (16, 216) adjacent to a sixth surface zone (40, 240) of the second metal element (16, 216) included in the weld joint (22), the material of the cement (28) being chosen to maintain its adhesion on the first zone (30, 230), the third zone (34, 234) and the fifth zone (38, 238) and its tightness with respect to the weld joint (22) when the ambient operating temperature is applied to the electrical device (2, 202).

2. The electrical device (2, 202) according to claim 1, wherein the first and second electrical components (4, 6) are positioned on the support plate (24) of the electrical connection means (26).

3. The electrical device (2, 202) according to claim 2, wherein the cement (28) covers, in a single piece and at once, the first electrical component (4), the second electrical component (6), the first metal element (10, 210), the second metal element (16, 216) and the weld joint (22).

4. The electrical device (2, 202) according to any one of claims 1 to 3, wherein the first metal element (10, 210) and the second metal element (16, 216) are each a different metal wire or metal ribbon having at least one extension direction not contained in the extension plane of the support plate (24).

5. The electrical device (2, 202) according to any one of claims 1 to 3, wherein the first metal element (10, 210) and the second metal element (16, 216) are each a different metal track positioned on the support plate (24).

6. The electrical device (2, 202) according to claim 5, comprising an adhesive layer (25) positioned between each of the metal tracks forming the first and second metal elements (10, 210, 16, 216) and the support plate (24).

7. The electrical device (2, 202) according to claim 6, **characterized in that** the adhesive layer (25) is made up of a material comprised in the set consisting of titanium, titanium oxide, tantalum, chromium, tungsten, silicon, iridium, iridium oxide, and aluminum doped with copper, titanium or silicon.

8. The electrical device (2, 202) according to any one of claims 1 to 7, wherein the first and second metal elements (10, 210, 16, 216) are made from a material comprised in the set consisting of platinum, tungsten, iridium, gold, nickel, copper and molybdenum; the support plate (24) is made from a material comprised in the set consisting of alumina, zirconia, aluminum nitride and polycrystalline gallium nitride, and the cement (28) is made from a material comprised in the set consisting of alumina-based ceramic pastes and silver flake-based ceramic pastes.

9. The electrical device (2, 202) according to any one of claims 1 to 8, wherein the first electrical component (4) is comprised in the set consisting of oscillators, filters, temperature and/or pressure sensors, stress sensors, physicochemical property sensors made from elastic surface wave or elastic volume wave or localized vibration probe piezoelectric transducers; and the second electrical component is comprised in the set consisting of oscillators, filters, temperature and/or pressure sensors, stress sensors, physicochemical property sensors made from surface wave, volume wave or localized vibration probe piezoelectric transducers and wireless antennas.

10. The electrical device (2, 202) according to any one of claims 1 to 9, wherein the first electrical component (4) is a surface wave temperature sensor, and the second electrical component (6) is a wireless antenna, the wireless antenna being made from a material comprised in the set consisting of chromium, nickel, alloys of chromium and nickel, gold, copper, stainless steel, titanium, platinum, iridium, molybdenum, zinc, tungsten.

11. A method (300) for manufacturing an electrical device (2, 202) designed to operate at a high ambient operating temperature, i.e. above 190°C, preferably above 250°C, more preferably above 600°C, comprising:
- a step (302) for providing a first electrical component (4), a second electrical component (6), and an electrically insulating support plate (24);
- a step (304) for providing a first metal element (10, 210) having a first end (12, 212) electrically connected to the first electrical component (4) and a second end (14, 214), and a second metal element (16, 216) having a third end (18, 218) electrically connected to the second electrical component (6) and a fourth end (20, 220); and
- a step (306) for connecting the second end (14, 214) of the first metal element (10, 210) and the fourth end (20, 220) of the second metal element (16, 216) using the weld joint (22) deposited on the support plate (24), the weld joint (22) having a melting temperature (Tf) lower than the ambient operating temperature (Ta) of the electrical device (2, 202);
**characterized in that** the method comprises a step (308) consisting of depositing a cement (28) so as to cover the entire exposed weld joint (22), to cover and adhere to a first surface zone (30, 230) of the support plate (24) adjacent to a second zone (32, 232) of the support plate (24) in contact with the weld joint (22), a third surface zone (34, 234) of the first metal element (10, 210) adjacent to a fourth surface zone (36, 236) of the first metal element (10, 210) included in the weld joint (22), and a fifth surface zone (38, 238) of the second metal element (16, 216) adjacent to a sixth surface zone (40, 240) of the second metal element (16, 216) included in the weld joint (22), the material of the cement (28) being chosen to maintain its adhesion on the first zone (30, 230), the third zone (34, 234) and the fifth zone (38, 238) and its tightness with respect to the weld joint (22) when the ambient operating temperature is applied to the electrical device (2, 202).

12. The method for manufacturing an electrical device (2, 202) according to claim 11, **characterized in that** the step (304) for providing the first and second metal elements (10, 210, 16, 216) includes the following steps:
- depositing a first adhesive layer and a second adhesive layer on the support plate (24) in the form of a first track and a second track;
- depositing the first and second metal elements (10, 210, 16, 216), respectively, on the first track and the second track, so as to form a first metal track and a second metal track, respectively.
